# EUROPEAN PATENT SPECIFICATION

(11) **EP 0 369 717 B1**
(45) Date of publication and mention of the grant of the patent: **10.08.1994**
(21) Application number: 89311740.8
(22) Date of filing: 13.11.1989
(51) Int. Cl.: H01L 31/068, H01L 31/18, H01L 27/142

(54) **A solar cell and a production method thereof**
Sonnenzelle und ihr Herstellungsverfahren
Cellule solaire et méthode de fabrication

(30) Priority: 16.11.1988 JP 290990/88
(43) Date of publication of application: 23.05.1990
(73) Proprietor: MITSUBISHI DENKI KABUSHIKI KAISHA, Tokyo (JP)
(72) Inventor: Hokuyo, Sigeru Mitsubishi Denki K.K., Itami-shi Hyogo-ken (JP); Oda, Takao Mitsubishi Denki K.K., Itami-shi Hyogo-ken (JP); Matsumoto, Hideo Mitsubishi Denki K.K., Itami-shi Hyogo-ken (JP)
(74) Representative: Beresford, Keith Denis Lewis

(56) References cited:
- DE-A- 3 517 414
- PATENT ABSTRACTS OF JAPAN vol. 7, no. 58 (E-163)(1203) 10 March 1983 ; & JP-A-57 204180
- PATENT ABSTRACTS OF JAPAN vol. 7, no. 33 (E-157)(1178) 09 February 1983 ; & JP-A-57 184255
- SOLAR CELLS. vol. 19, no. 1, November 1986, LAUSANNE CH pages 97 - 108; M.A.GREEN ET AL.: "THERMAL PERFORMANCE OF INTEGRAL BYPASS DIODE SOLAR CELL MODULES"
- 19TH IEEE PHOTOVOLTAIC SPECIALISTS CONFERENCE 04 August 1987, NEW-ORLEANS, LOUISIANA pages 267 - 272; M.YAMAGUCHI ET AL.: "HIGH EFFICIENCY GaAs AND InP THIN-FILM SOLAR CELLS FABRICATED ON Si SUBSTRATES"

## Description

### FIELD OF THE INVENTION

The present invention relates to a solar cell and a production method thereof, and more particularly, to that capable of preventing destruction due to reverse direction voltage which arises when a portion of a solar cell among a plurality of serially connected solar cells comes into shade while using the solar cell device for light-electricity generation, and capable of preventing the reduction in the output of the solar cell module to the minimum extent.

### BACKGROUND OF THE INVENTION

A solar cell fundamentally comprises a diode having a pn junction. When solar cells are to be used for generation of electricity in practical use, a plurality of solar cells are serially connected to obtain a significant voltage as a whole generation voltage which is a sum of generation voltages of the respective cells. When a portion of one of the serially connected cells comes into shade, however, the cell having such a shaded portion is subjected to a reverse direction (when the solar cell is considered as a diode) voltage which is generated by the other serially connected cells. In such case, the cell having a shaded portion will block the current, thereby reducing the output of the solar cell module to a great extent. Furthermore, when the reverse direction blocking voltage of the solar cell is low, a destruction phenomenon arises and the function of the solar cell is reduced or deteriorated.

In order to prevent such phenomenon, it is necessary to enhance the reverse direction blocking voltage of the solar cell or to insert diodes in reverse direction in parallel with the junction of the solar cell within such a range that the generated total voltage of the series connection solar cells does not exceed the reverse direction blocking capability of a cell, thereby to bypass the reverse direction voltage which is unexpectedly applied to the cell.

Herein, the enhancement in the reverse direction blocking voltage of the solar cell is realized by lowering the impurity concentration in the base layer. However, solar cells are generally required to have shallow pn junctions, and in particular, in solar cells used in space, the depth of pn junction is required to be below 0.3 to 0.5 micrometer in order to enhance the short wavelength sensitivity. Herein, to realize such pn junction by conducting diffusion into a base layer having a required impurity concentration in order to obtain a blocking voltage of several hundreds volt is possible experimentally but is quite difficult in mass production. Furthermore, in a GaAs solar cell, it is difficult to produce a base layer of low impurity concentration due to such as mixing of impurities such as O₂ into the cell in the process of crystal growth, and then only above several tens volts to the upmost is obtained as the reverse direction blocking voltage. In this way, there is a limitation in the enhancement of the reverse direction blocking voltage in the solar cell and this results in difficulty in the use thereof in the light voltage generation system.

Furthermore, a device including a diode in reversely parallel with the junction of the solar cell thereby to bypass the reverse direction voltage which is to be applied to the element is thought to be effective as a system but requires a space for the external reverse parallel diodes. This leads to a costly device due to the diode connection and further lowers the system reliability due to the increase in the parts number. Especially, in the use thereof in space which requires a high reliability, these will become important problems.

There is another method of producing independent diodes which are connected in reversely parallel with other cells of a solar cell device and thereby to obtain the same effects as the insertion of the external reverse parallel diodes. In order to enable inclusion of a bypass diode in simple in this way, it is thought of to electrically separate the n(p) layer of the solar cell from the n(p) layer of the bypass diode, and produce a two cell (p-n junction) structure separated from each other on an insulator substrate, and make those function as a solar cell function portion and as a bypass diode portion, respectively.

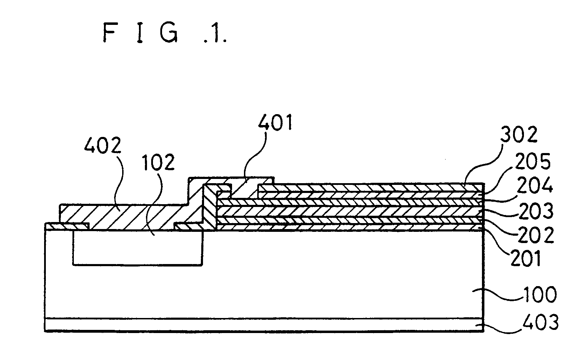

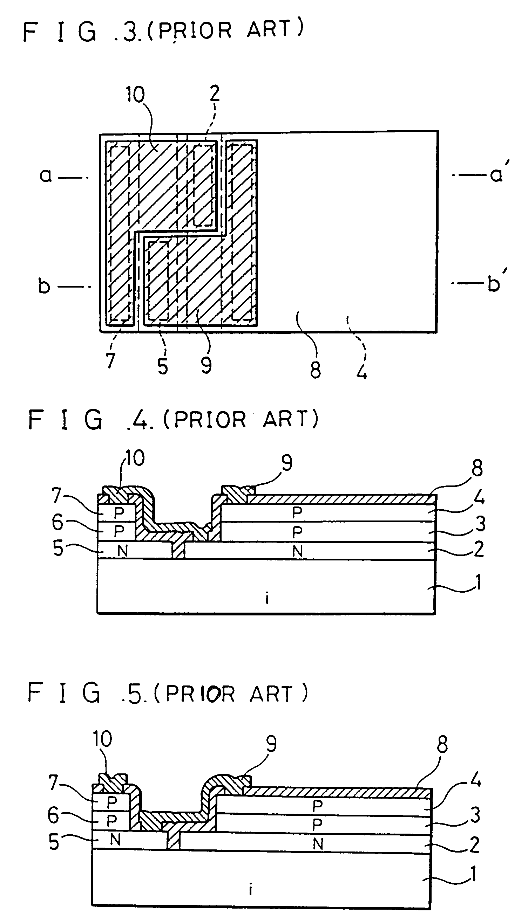

For example, figures 3 to 5 show a solar cell element of such a structure disclosed in Japanese Laid-Open Patent Publication No. Sho 57-204180. Figure 3 shows a plan view of such solar cell, and figures 4 and 5 show cross-sections in lines A - A′ and B - B′ of figure 1, respectively.

In these figures, reference numeral 1 designates a semi-insulating substrate such as GaAs. An n type GaAs layer 2, a p type GaAs layer 3, and a p type AlGaAs layer 4 are successively laminated on the substrate 1 at a broader side thereof and an n type GaAs layer 5, a p type GaAs layer 6, and a p type AlGaAs layer 7 are successively laminated on the substrate 1 at a narrower side thereof. The layers from n type GaAs layer 2 to p type AlGaAs layer 4 constitute a solar cell and the layers from n type GaAs layer 5 to p type AlGaAs layer 7 produce a reverse direction voltage blocking diode. Reference numeral 8 designates an insulating film which functions also as a reflection preventing film. The p type AlGaAs layer 4 and the n type GaAs layer 5 are connected by a positive side electrode 9, and the n type GaAs layer 2 and the p type AlGaAs layer 7 are connected by a negative side electrode 10 with each other, respectively. Accordingly, in the usual state of the above-described construction, a negative voltage is generated at the n type GaAs layer 2 and a positive voltage is generated at the p type GaAs layer 3 which layers 2 and 3 produce a solar cell. However, because it becomes in a reverse direction against the diode produced by the n type GaAs layer 5 and the p type GaAs layer 6, this diode is not affected on the solar cell operation, and when a reverse direction voltage is applied to the layers 2 and 3, that is, a positive voltage is applied to the n type GaAs layer 2 and a negative voltage is applied to the p type GaAs layer 3, a negative voltage will be applied to the n type GaAs layer 5 and a positive voltage will be applied to the p type GaAs layer 6 thereby to result a forward direction voltage for the diode which is constituted by the n type GaAs layer 5 and the p type GaAs layer 6. Then, only a voltage resulting from the forward direction voltage drop of the diode is applied to the n type GaAs layer 2 and the p type GaAs layer 3 of the solar cell. As a result of that, the solar cell will be protected by the diode from the reverse direction voltage.

In case of a solar cell having a structure shown in figures 3 to 5, however, since a semi-insulating substrate is used as the substrate 1, it is not possible to produce an electrode opposite the light receiving surface of the solar cell function portion at the rear surface of the substrate. On the contrary, it is required to expose a portion of the n type GaAs layer 2 which is produced on the insulating substrate at a portion of the light receiving surface, and to produce an n type electrode 10 thereon. Therefore, in cases of large area solar cells, the internal series resistance of the solar cell is increased by the lateral direction resistance of the n type GaAs layer 2, and the conversion efficiency is lowered. Furthermore, by producing an n type layer 2 at a portion of the light receiving surface, the effective light receiving area is reduced and the conversion efficiency is lowered. Furthermore, in order to expose a portion of the n type layer 2 at the portion of the light receiving surface, the etching depth has to be controlled strictly while selectively removing the p type layer 3 by such as wet etching. However, in cases where the p type layer 3 and the n type layer 2 are produced by the same material as such, the strict control of the etching depth is quite difficult. Furthermore, when using a solar cell with connecting a plurality of solar cells in series, a considerably large amount of heat is applied to the welding portion of the front surface electrode and the external connector may amount partially to a temperature above 500°C. However, in cases of GaAs solar cell, the depth of the pn junction at the solar cell function portion has a limitation of about 0.5 micrometer as discussed above, and there arise problems that the pn junction is subjected to damages due to heat, thereby deteriorating characteristics or that cracks of GaAs are likely to generate. These further result in restrictions to the welding conditions.

### SUMMARY OF THE INVENTION

It is an object of the present invention to provide a solar cell which, including reverse parallel diodes on the same semiconductor substrate, is capable of preventing electro-motive force generation of the reverse parallel diodes.

Another object of the present invention is to provide a production method of a solar cell capable of producing a high efficiency solar cell by a simple process.

Other objects and advantages of the present invention will become apparent from the detailed description given hereinafter; it should be understood, however, that the detailed description and specific embodiment are given by way of illustration only.

In a solar cell according to the present invention, a second conductivity type semiconductor region is produced as a reverse parallel diode at a solar cell function portion production of first conductivity type semiconductor substrate, and a solar cell function portion is produced by successively producing a second conductivity type first semiconductor layer and a first conductivity type second semiconductor layer on a substrate surface except for the reverse direction parallel diode section. Then, the pn junction between the semiconductor substrate surface and the solar cell function portion is made a junction having almost no reverse direction voltage blocking capability. Furthermore, a surface electrode metal layer which connects a second semiconductor layer and the semiconductor region is produced so as to cover the entire surface of the reverse parallel diode portion and the other electrode is produced at the rear surface of substrate. Accordingly, the light of wavelength contributing to the light generation which can reach the pn junction portion of the reverse parallel diode can be perfectly intercepted, thereby enabling prevention of electro-motive force generation of the reverse parallel diodes. Furthermore, in a case where a portion of the solar cell connected in series comes into shade, the reverse parallel diode section is biased in a forward direction and it is prevented that a reverse voltage should be applied to the pn junction having an original function as a solar cell. Furthermore, since the reverse parallel diode is produced electrically separated by way of arranging pn junctions in a substrate, the production process of a reverse parallel diode can be simplified to a great extent. Furthermore, the electrode portion above the reverse parallel diode can be used for the external connector welding portion, thereby preventing reduction in the effective light receiving area.

The solar cell and its method of manufacture according to the invention are featured in claim 1 and claim 10 respectively.

### BRIEF DESCRIPTION OF THE DRAWINGS

Figure 1 is a diagram showing a cross-sectional structure of a solar cell according to an embodiment of the present invention;
Figures 2(a) to (e) are diagrams showing respective production process steps for producing the solar cell of figure 1;
Figure 3 is a plan view showing a structure of a prior art solar cell;
Figure 4 is a cross-sectional view in line a - a' of figure 3; and
Figure 5 is a cross-sectional view in line b - b' of figure 3.

### DETAILED DESCRIPTION OF THE PREFERRED EMBODIMENT

An embodiment of the present invention will be described in detail with reference to the drawings.

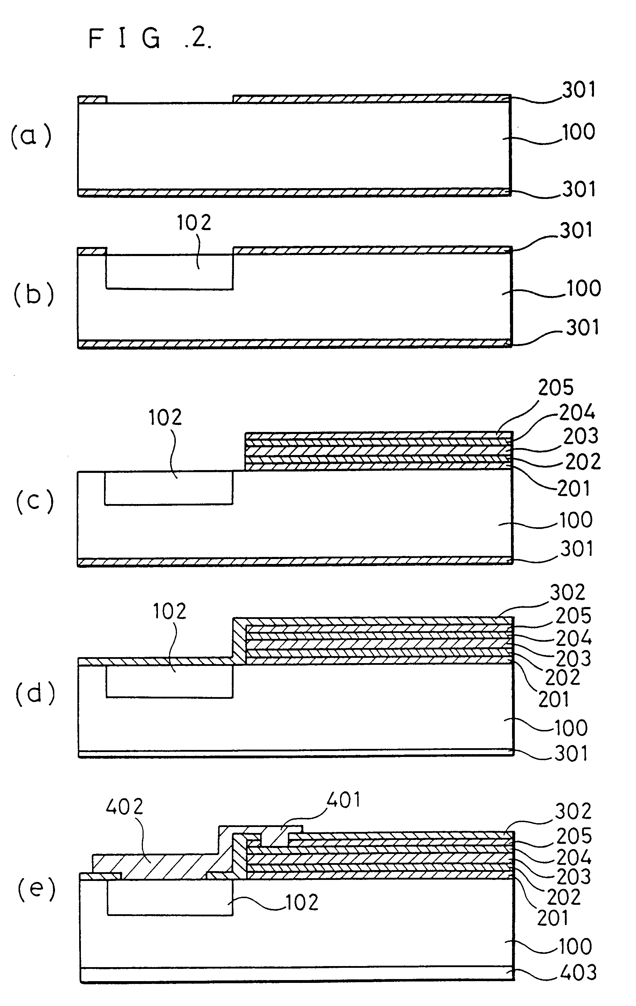

Figure 1 shows a cross-sectional structure of a solar cell according to an embodiment of the present invention. In figure 1, reference numeral 100 designates a p type Ge substrate. An n type Ge region 102 is produced on the main surface of the p type Ge substrate 100. An n type GaAs high concentration impurity layer 201 is disposed on the p type Ge substrate 100. A lattice matching layer 202 is disposed on the n type GaAs high concentration impurity layer 201. An n type GaAs layer 203 is disposed on the lattice matching layer 202. A p type GaAs layer 204 is disposed on the n type GaAs layer 203. An AlGaAs layer 205 is disposed on the p type GaAs layer 204. A selective diffusion mask 301 (in figure 2) is used for selective diffusion of impurities for producing the n type Ge region 102. A reflection preventing layer 302 is disposed on the AlGaAs layer 205. Reference numeral 401 designates a solar cell p-side electrode, reference numeral 402 designates a solar cell p-side welding electrode integrated with the electrode 401, and reference numeral 403 designates a solar cell n-side electrode.

Figures 2(a) to (e) show production process steps for producing the solar cell of figure 1, and the production process will be described with reference to figure 2.

First of all, as shown in figure 2(a), a silicon nitride film 301 is produced on both surfaces of the p type Ge substrate 100 having substrate thickness of 100 to 300 micrometer and a silicon nitride film 301 as a selective diffusion mask is produced to a thickness of about 1000 Angstroms (10Å = 1 nm) by CVD (Chemical Vapor Deposition). Herein, in order to ease to take an ohmic contact with the n type GaAs high concentration impurity layer which will be produced later, the impurity concentration of the surface of substrate is made at least above 1 x 10¹⁷ cm⁻³ or preferably about 1 x 10¹⁸ cm⁻³. That is, when a substrate having impurity concentration of below 1 x 10¹⁷ cm⁻³ is used, a high concentration p type layer is required to be produced by diffusion of boron into a predetermined portion of a region of the surface of p type substrate for producing a solar cell function portion.

Thereafter, as shown in figure 2(b), a silicon nitride film 301 at a predetermined portion is removed by photolithography, and diffusion of P is conducted through this aperture thereby to produce an n type Ge region 102. Thereafter, as shown in figure 2(c), the silicon nitride film 301 at the surface side (light receiving surface side) is removed, and thereafter in order to produce a pn junction having a function as a GaAs solar cell, an n type high impurity concentration GaAs layer 201 of film thickness of 100 to 1000 Angstroms, a lattice matching layer 202 comprising a superlattice layer which comprises alternatively laminated AlGaAs and GaAs layers having film thicknesses of 100 Angstroms, respectively, an n type GaAs layer 203 of film thickness of 3 to 5 micrometers, a p type GaAs layer 204 of film thickness of 0.3 to 0.5 micrometers, and a p type AlₓGa₁₋ₓAs layer (x = 0.8 to 0.9) 205 having film thickness below 0.1 micrometer are successively grown by such as MOCVD (Metal Organic Chemical Vapor Deposition) or MBE (Molecular Beam Epitaxy) method. Then, the impurity concentration of the n type high impurity concentration GaAs layer 201 is desired to be below about 1 x 10¹⁸ cm⁻³. Furthermore, a predetermined portion of the epitaxy layers including at least a pn junction portion of the Ge substrate surface is removed by etching, thereby separating the solar cell function portion and the reverse parallel diode portion from each other.

Thereafter, as shown in figure 2(d), a silicon nitride film 302 as a reflection preventing film and insulating film for metal wiring are produced.

Thereafter, as shown in figure 2(e), portions of the silicon nitride film 302 and the p type AlGaAs layer 205 at predetermined regions of the front surface and rear surface are removed by photolithography, and an electrode metal layer is produced at predetermined portions of the reverse parallel diode and the solar cell function portion by sputtering or deposition. That is, the front surface electrode 401 of solar cell is produced so as to connect the p type GaAs layer 204 and the n type Ge region 102, and the rear surface electrode 403 is produced at the entire rear surface of p type Ge substrate 100. Then, the front surface electrode is produced so as to completely cover a portion including the pn junction portion at the surface of the Ge substrate 100 and n type Ge region 102. Furthermore, when the solar cell is used in space for such as power supply of an artificial satellite, the connection between the electrode of solar cell and the external connector is often conducted by welding method such as parallel gap method. Then, the front surface electrode is required to have an area of about 5 mm x 10 mm to be used as a welding portion with the external connection connector, and the electrode 401 on the n type Ge region 102 is desired to be pattern designed so as to satisfy this condition.

The device will operate as follows.

In the solar cell of such construction, when a light enters into the light receiving surface, a light electromotive force is generated between the p type GaAs layer 204 and the n type GaAs layer 203, and it functions as a battery which produces a positive voltage at the anode electrode 401 and a negative voltage at the cathode electrode 403. Although the reverse parallel diode comprising pn junction produced by the p type Ge layer 100 and the n type Ge region 102 has an electro-generating function of reverse direction which is reverse to the original electro-generation direction of solar cell, since the entire surface is covered by the electrode metal 402 and the incident light is intercepted, there arises generation of electricity in the reverse direction, thereby not obstructing the solar cell function. Furthermore, in the solar cell module serially connected through the external connection electrodes 401 and 403, when a portion of solar cell comes into shade, a reverse voltage is applied and the anode electrode 401 is biased at minus voltage while the cathode electrode 403 is biased at positive voltage. However, the reverse parallel diode portion is biased in a forward direction in this case, and a current flows from the cathode electrode 403 through the reverse parallel diode portion to the anode electrode 401. Accordingly, a reverse direction voltage is not applied to the pn junction having an original electro-motive force function as a solar cell.

As described above, the solar cell of the present invention has a reverse direction conducting capability and the element will not be destroyed by a reverse direction voltage. Furthermore, because there is no necessity of inserting a diode at the outside, the number of parts will not increase as a whole system. Furthermore, the reverse parallel diode can be made independent by a selective etching which is conducted after producing a pn junction at the substrate, thereby enabling simplification of process. Furthermore, while welding the solar cell front surface electrode 401 with the external connector, by making the electrode onto the n type Ge region 102 as a welding portion, damages to the pn junction at the solar cell function portion and cracks into the GaAs can be perfectly prevented. Furthermore, the adhesion intensity of the electrode metal to the semiconductor substrate is superior than that onto the insulating film and the electrode on the n type Ge layer 102 becomes a superior welding electrode. Further, by producing a welding electrode which is required to have an area of some degree on the n type Ge region 102, it is possible to suppress the reduction in the effective light receiving area due to the production of bypass diodes at the light receiving surface.

While in the above-described embodiment, a p on n type GaAs/Ge solar cell is described, the present invention can be applied to any solar cell such as GaAs/Si solar cell without being restricted to p on n or n on p solar cell.

In the production method of the above-described embodiment, a solar cell function portion including a pn junction is produced on the entire surface of substrate and thereafter the reverse parallel diode section is removed by etching. However, layers including pn junction may be produced by epitaxy after an epitaxial growth blocking layer such as silicon nitride film are produced at a predetermined region including a pn junction portion and n(p) type Ge layer at the surface of Ge substrate before producing a solar cell function portion. Then, a solar cell function portion which is independent from the beginning can be produced.

As is evident from the foregoing description, according to the present invention, a bypass diode is produced by providing a semiconductor layer having a reverse conductivity type to that of substrate at a portion of the solar cell function portion production surface of a semiconductor substrate, and a solar cell function portion is produced on the substrate except for the bypass diode production region. Meanwhile the pn junction between the semiconductor substrate surface and the solar cell function portion is made a junction having almost no reverse direction voltage blocking capability, and one side electrode is produced so as to connect the solar cell function portion and the bypass diode portion thereby to cover the entire surface of the bypass diode portion by this surface electrode metal layer, and further the other side electrode is produced at the rear surface of substrate. Accordingly, light of wavelength contributing to the light electro-motive force generation which can reach the pn junction portion of the reverse parallel diode can be perfectly cut, and generation of electro-motive force of the reverse parallel diode can be prevented. Furthermore, since the reverse parallel diode portion is biased in a forward direction when a portion of the solar cell connected in series comes into shade, it is possible to prevent that a reverse voltage should be applied to a pn junction having an original solar cell function. Furthermore, since there is no necessity of inserting a diode at the outside, it is not necessary to increase the parts number as a system and since the reverse parallel diode is made independent by producing it at the same time as the production of the solar cell function portion and thereafter conducting selective etching of the same thereby to separate them from each other, which enables simplification of process. Furthermore, while welding the solar cell surface electrode to an external connector, by making the electrode on the reverse parallel diode portion as a welding portion, damages and cracks to the pn junction of the solar cell function portion can be perfectly prevented and reduction in the effective light receiving area due to the production of the bypass diode at the light receiving surface can be suppressed to the minimum extent.

## Claims

1. A solar cell comprising:
a first conductivity type semiconductor substrate (100) having opposed first and second main surfaces;
a second conductivity type semiconductor region (102) extending from a portion of said first main surface into said semiconductor substrate (100);
a second conductivity type first semiconductor layer (203) which, produced on said first main surface of said semiconductor substrate (100) except for said portion of first main surface , produces a pn junction with said semiconductor substrate (100) having almost no reverse direction voltage blocking capability;
a first conductivity type second semiconductor layer (204) produced on said first semiconductor layer (203);
a first electrode (401,402) provided so as to cover said semiconductor region (102) and which connects said second semiconductor layer (204) with said semiconductor region (102); and
a second electrode (403) produced at the second main surface of said semiconductor substrate (100).

2. A solar cell as defined in claim 1, wherein a second conductivity type high impurity concentration semiconductor layer (201) is provided between said first conductivity type semiconductor substrate (100) and said second conductivity type first semiconductor layer (203).

3. A solar cell as defined in claim 2, wherein a lattice matching layer (202) is provided between said second conductivity type high impurity concentration semiconductor layer (201) and said second conductivity type first semiconductor layer (203).

4. A solar cell as defined in claim 1, wherein a window layer (205) is provided on said second semiconductor layer (204).

5. A solar cell as defined in claim 1, wherein a reflection preventing film (302) is provided on a portion other than said first electrode (401,402) on said first main surface.

6. A solar cell as defined in claim 1, wherein said semiconductor substrate (100) is formed of Ge and the first and second layers are formed of GaAs.

7. A solar cell as defined in claim 6, wherein said semiconductor substrate (100) comprises a p type Ge layer, said semiconductor region (102) comprises an n type Ge region, said first semiconductor layer (203) comprises an n type GaAs layer, and said second semiconductor layer (204) comprises a p type GaAs layer.

8. A solar cell as defined in claim 1, wherein said semiconductor substrate (100) is formed of Si and said first and second layers are formed of GaAs.

9. A solar cell as defined in claim 1, wherein a zone (402) of said first electrode (401,402) which is produced on said first semiconductor region (102), forms an external connector connection portion.

10. A method of producing a solar cell according to claim 1 comprising:
a first step of producing a second conductivity type semiconductor region (102) at a portion of said first main surface of said first conductivity type semiconductor substrate (100);
a second step of producing a second conductivity type first semiconductor layer (203) on said first main surface of said semiconductor substrate (100) except on said semiconductor region, which layer produces a pn junction with said semiconductor substrate (100) having almost no reverse direction voltage blocking capability and producing a first conductivity type second semiconductor layer (204) on said first semiconductor layer (203);
a third step of producing an insulating film (302) so as to cover the entire surface of said first main surface and removing a desired portion of said insulating film (302), and producing said first electrode (401,402) which, covering the entire surface on said semiconductor region (102), connects said semiconductor region (102) and said second semiconductor layer (204); and
a fourth step of producing said second electrode (403) on the second main surface of said semiconductor substrate (100).

11. A method of producing a solar cell as defined in claim 10, wherein said second step includes a step of producing a second conductivity type high impurity concentration semiconductor layer (201) and a lattice matching layer (202) successively on said semiconductor substrate (100) before producing a second conductivity type first semiconductor layer (203) on said semiconductor substrate (100).

12. A method of producing a solar cell as defined in claim 10, wherein said second step includes steps of producing a second conductivity type first semiconductor layer (203), and a first conductivity type second semiconductor layer (204) successively on said semiconductor substrate (100), and thereafter removing portions thereof corresponding to a portion above said semiconductor region (102) by etching.

13. A method of producing a solar cell as defined in claim 10, wherein said second step includes step of producing an epitaxial growth blocking layer (201,202) at a predetermined position including a portion above said semiconductor region (102) of said semiconductor substrate surface, and thereafter producing a second conductivity type first semiconductor layer (203) and a first conductivity type second semiconductor layer (204) successively.

14. A method of producing a solar cell as defined in claim 10, wherein said second step includes steps of producing a window layer (205) on said second semiconductor layer (204).

15. A method of producing a solar cell as defined in claim 10, wherein semiconductor substrate (100) is formed of Ge and the first and second semiconductor layers are formed of GaAs.

16. A method of producing a solar cell as defined in claim 15, wherein said semiconductor substrate (100) comprises a p type Ge layer, said semiconductor region (102) comprises an n type Ge layer, said first semiconductor layer (203) comprises an n type GaAs layer, and said second semiconductor layer (204) comprises a p type GaAs layer.

17. A method of producing a solar cell as defined in claim 10, wherein said semiconductor substrate if formed of Si and the second and third semiconductor layers are formed of GaAs.

18. A method of producing a solar cell as defined in claim 10, wherein a zone (402) above said semiconductor region (102) among zones of said first electrode (401,402) which is produced on said first main surface of said semiconductor substrate (100), is made an external connector connection portion.

## Patentansprüche

1. Sonnenzelle, umfassend:
ein Halbleitersubstrat (100) von einem ersten Leitfähigkeitstyp mit gegenüberliegenden ersten und zweiten Haupt-Oberflächen;
einen Halbleiterbereich (102) von einem zweiten Leitfähigkeitstyp, der sich von einem Teil von der ersten Haupt-Oberfläche in das Halbleitersubstrat (100) erstreckt;
eine erste Halbleiterschicht (203) von einem zweiten Leitfähigkeitstyp, die auf der ersten Haupt-Oberfläche des Halbleitersubstrats (100) außer auf dem Teil von der ersten Haupt-Oberfläche hergestellt ist und einen p-n-Übergang mit dem Halbleitersubstrat (100) mit fast keiner Sperreigenschaft bei Spannung in Rückwärtsrichtung bildet;
eine zweite Halbleiterschicht (204) von einem ersten Leitfähigkeitstyp, die auf der ersten Halbleiterschicht (203) hergestellt ist;
eine erste Elektrode (401, 402), die bereitgestellt ist, so daß sie den Halbleiterbereich (102) bedeckt, und die die zweite Halbleiterschicht (204) mit dem Halbleiterbereich (102) verbindet; und
eine zweite Elektrode (403), die an der zweiten Haupt-Oberfläche des Halbleiter-Substrats (100) hergestellt ist.

2. Sonnenzelle nach Anspruch 1, wobei eine Halbleiterschicht (201) vom zweiten Leitfähigkeitstyp mit hoher Verunreinigungskonzentration zwischen dem Halbleitersubstrat (100) vom ersten Leitfähigkeitstyp und der ersten Halbleiterschicht (203) vom zweiten Leitfähigkeitstyp bereitgestellt ist.

3. Sonnenzelle nach Anspruch 2, wobei eine Gitter-Anpassungsschicht (202) zwischen der Halbleiterschicht (201) vom zweiten Leitfähigkeitstyp mit hoher Verunreinigungskonzentration und der ersten Halbleiterschicht (203) vom zweiten Leitfähigkeitstyp bereitgestellt ist.

4. Sonnenzelle nach Anspruch 1, wobei eine Fensterschicht (205) auf der zweiten Halbleiterschicht (204) bereitgestellt ist.

5. Sonnenzelle nach Anspruch 1, wobei ein Reflexion verhindernder Film (302) auf einem Teil auf der ersten Haupt-Oberfläche, außer auf der ersten Elektrode (401, 402), vorgesehen ist.

6. Sonnenzelle nach Anspruch 1, wobei das Halbleiter-Substrat (100) aus Ge gebildet ist und die erste und die zweite Schicht aus GaAs gebildet sind.

7. Sonnenzelle nach Anspruch 6, wobei das Halbleiter-Substrat (100) eine Ge-Schicht vom p-Typ umfaßt, der Halbleiterbereich (102) einen Ge-Bereich vom n-Typ umfaßt, die erste Halbleiterschicht (203) eine GaAs-Schicht vom n-Typ umfaßt und die zweite Halbleiterschicht (204) eine GaAs-Schicht vom p-Typ umfaßt.

8. Sonnenzelle nach Anspruch 1, wobei das Halbleitersubstrat (100) aus Si gebildet ist und die erste und die zweite Schicht aus GaAs gebildet sind.

9. Sonnenzelle nach Anspruch 1, wobei eine Zone (402) der ersten Elektrode (401, 402), die auf dem ersten Halbleiterbereich (102) gebildet ist, einen Verbindungsteil zu dem äußeren Verbindungsstück bildet.

10. Verfahren zur Herstellung einer Sonnenzelle gemäß Anspruch 1, umfassend:
einen ersten Schritt zur Erzeugung eines Halbleiterbereichs (102) vom zweiten Leitfähigkeitstyp an einem Teil von der ersten Haupt-Oberfläche des Halbleiter-Substrats (100) vom ersten Leitfähigkeitstyp;
einen zweiten Schritt zur Erzeugung einer ersten Halbleiterschicht (203) vom zweiten Leitfähigkeitstyp auf der ersten Haupt-Oberfläche des Halbleiter-Substrats (100), außer auf dem Halbleiterbereich, wobei die Schicht einen p-n-Übergang mit dem Halbleitersubstrat (100) mit fast keiner Sperreigenschaft bei Spannung in Rückwärtsrichtung bildet, und zur Erzeugung einer zweiten Halbleiterschicht (204) vom ersten Leitfähigkeitstyp auf der ersten Halbleiterschicht (203);
einen dritten Schritt zur Herstellung eines isolierenden Films (302), so daß er die gesamte Oberfläche der ersten Haupt-Oberfläche bedeckt, und zum Entfernen eines gewünschten Teils von dem isolierenden Film (302) und zur Erzeugung der ersten Elektrode (401, 402), die die gesamte Oberfläche auf dem Halbleiterbereich (102) bedeckt und den Halbleiterbereich (102) und die zweite Halbleiterschicht (204) verbindet; und
einen vierten Schritt zur Erzeugung der zweiten Elektrode (403) auf der zweiten Haupt-Oberfläche des Halbleiter-Substrats (100).

11. Verfahren zur Herstellung einer Sonnenzelle nach Anspruch 10, wobei der zweite Schritt einen Schritt zur Erzeugung einer Halbleiterschicht (201) vom zweiten Leitfähigkeitstyp mit hoher Verunreinigungskonzentration und darauffolgend einer Gitteranpassungsschicht (202) auf dem Halbleitersubstrat (100) umfaßt, bevor eine erste Halbleiterschicht (203) vom zweiten Leitfähigkeitstyp auf dem Halbleiter-Substrat (100) hergestellt wird.

12. Verfahren zur Herstellung einer Sonnenzelle nach Anspruch 10, wobei der zweite Schritt Schritte zur Bildung einer ersten Halbleiterschicht (203) vom zweiten Leitfähigkeitstyp und darauffolgend einer zweiten Halbleiterschicht (204) vom ersten Leitfähigkeitstyp auf dem Halbleiter-Substrat (100) und danach zur Entfernung durch Ätzen von Teilen dieser Schichten, die einem Teil oberhalb des Halbleiterbereichs (102) entsprechen, umfaßt.

13. Verfahren zur Herstellung einer Sonnenzelle nach Anspruch 10, wobei der zweite Schritt Schritte zur Bildung einer mit Epitaxie gewachsenen Sperrschicht (201, 202) bei einer vorbestimmten Position einschließlich eines Teils oberhalb des Halbleiterbereichs (102) der Halbleiter-Substratoberfläche und zur Erzeugung einer ersten Halbleiterschicht (203) vom zweiten Leitfähigkeitstyp danach und darauffolgend einer zweiten Halbleiterschicht (204) vom ersten Leitfähigkeitstyp umfaßt.

14. Verfahren zur Herstellung einer Sonnenzelle nach Anspruch 10, wobei der zweite Schritt Schritte zur Bildung einer Fensterschicht (205) auf der zweiten Halbleiterschicht (204) umfaßt.

15. Verfahren zur Herstellung einer Sonnenzelle nach Anspruch 10, wobei das Halbleiter-Substrat (100) aus Ge gebildet wird und die erste und die zweite Halbleiterschicht aus GaAs gebildet werden.

16. Verfahren zur Herstellung einer Sonnenzelle nach Anspruch 15, wobei das Halbleiter-Substrat (100) eine Ge-Schicht vom p-Typ umfaßt, der Halbleiterbereich (102) eine Ge-Schicht vom n-Typ umfaßt, die erste Halbleiterschicht (203) eine GaAs-Schicht vom n-Typ umfaßt und die zweite Halbleiterschicht (204) eine GaAs-Schicht vom p-Typ umfaßt.

17. Verfahren zur Herstellung einer Sonnenzelle nach Anspruch 10, wobei das Halbleitersubstrat aus Si gebildet wird und die zweite und die dritte Halbleiter-Schicht aus GaAs gebildet werden.

18. Verfahren zur Herstellung einer Sonnenzelle nach Anspruch 10, wobei eine Zone (402) oberhalb des Halbleiterbereichs (102) aus Zonen der ersten Elektrode (401, 402), die auf der ersten Haupt-Oberfläche des Halbleiter-Substrats (100) gebildet ist, zu einem Verbindungsteil zu dem äußeren Verbindungsstück gemacht wird.

## Revendications

1. Une cellule solaire comprenant :
un substrat semiconducteur (100) d'un premier type de conductivité ayant des première et seconde surfaces principales opposées;
une région de semiconducteur (102) d'un second type de conductivité s'étendant à partir d'une partie de la première surface principale jusqu'à l'intérieur du substrat semiconducteur (100);
une première couche de semiconducteur (203) du second type de conductivité, qui est formée sur la première surface principale du substrat semiconducteur (100), sauf sur la partie précitée de la première surface principale, et qui forme avec le substrat semiconducteur (100) une jonction pn n'ayant presque aucune possibilité de blocage de tension en sens inverse;
une seconde couche de semiconducteur (204) du premier type de conductivité formée sur la première couche de semiconducteur (203);
une première électrode (401, 402) formée de façon à recouvrir la première région de semiconducteur (102) et qui connecte la seconde région de semiconducteur (204) à la première région de semiconducteur (102); et
une seconde électrode (403) formée sur la seconde surface principale du substrat semiconducteur (100).

2. Une cellule solaire selon la revendication 1, dans laquelle une couche de semiconducteur (201) du second type de conductivité, ayant une concentration en impuretés élevée, est formée entre le substrat semiconducteur (100) du premier type de conductivité et la première couche de semiconducteur (203) du second type de conductivité.

3. Une cellule solaire selon la revendication 2, dans laquelle une couche d'adaptation de réseaux cristallins (202) est formée entre la couche de semiconducteur (201) du second type de conductivité ayant une concentration en impuretés élevée et la première couche de semiconducteur (203) du second type de conductivité.

4. Une cellule solaire selon la revendication 1, dans laquelle une couche de fenêtre (205) est formée sur la seconde couche de semiconducteur (204).

5. Une cellule solaire selon la revendication 1, dans laquelle une pellicule anti-réflexion (302) est formée sur une partie autre que la première électrode (401, 402) sur la première surface principale.

6. Une cellule solaire selon la revendication 1, dans laquelle le substrat semiconducteur (100) consiste en Ge et les première et seconde couches consistent en GaAs.

7. Une cellule solaire selon la revendication 6, dans laquelle le substrat semiconducteur (100) consiste en une couche de Ge de type p, la première région de semiconducteur (102) consiste en une région de Ge de type n, la première couche de semiconducteur (203) consiste en une couche de GaAs de type n, et la seconde région de semiconducteur (204) consiste en une couche de GaAs de type p.

8. Une cellule solaire selon la revendication 1, dans laquelle le substrat semiconducteur (100) consiste en Si et les première et seconde couches consistent en GaAs.

9. Une cellule solaire selon la revendication 1, dans laquelle une zone (402) de la première électrode (401, 402) qui est formée sur la première région de semiconducteur (102) forme une partie de connexion pour un connecteur externe.

10. Un procédé de fabrication d'une cellule solaire conforme à la revendication 1, comprenant :
une première étape consistant à produire une région de semiconducteur (102) du second type de conductivité sur une partie de la première surface principale du substrat semiconducteur (100) du premier type de conductivité;
une seconde étape consistant à produire une première couche de semiconducteur (203) du second type de conductivité sur la première surface principale du substrat semiconducteur (100), sauf sur la région de semiconducteur précitée, cette couche produisant avec le substrat semiconducteur (100) une jonction pn n'ayant presque aucune capacité de blocage de tension inverse, et à produire une seconde couche de semiconducteur (204) du premier type de conductivité sur la première couche de semiconducteur (203);
une troisième étape consistant à produire une pellicule isolante (302) de façon à recouvrir la totalité de l'étendue de la première surface principale et à enlever une partie désirée de cette pellicule isolante (302), et à produire la première électrode (401, 402) qui recouvre la totalité de la surface de la région de semiconducteur (102) et qui connecte la région de semiconducteur (102) et la seconde couche de semiconducteur (204); et
une quatrième étape qui consiste à produire la seconde électrode (403) sur la seconde surface principale du substrat semiconducteur (100).

11. Un procédé de fabrication d'une cellule solaire selon la revendication 10, dans lequel la seconde étape comprend une étape qui consiste à former successivement sur le substrat semiconducteur (100) une couche de semiconducteur (201) du second type de conductivité ayant une concentration en impuretés élevée, et une couche d'adaptation de réseaux cristallins (202), avant de produire une première couche de semiconducteur (203) du second type de conductivité sur le substrat semiconducteur (100).

12. Un procédé de fabrication d'une cellule solaire selon la revendication 10, dans lequel la seconde étape comprend les étapes qui consistent à produire successivement sur le substrat semiconducteur (100) une première couche de semiconducteur (203) du second type de conductivité et une seconde couche de semiconducteur (204) du premier type de conductivité, et à enlever ensuite par attaque chimique des parties de ces couches qui correspondent à une partie se trouvant au-dessus de la région de semiconducteur (102).

13. Un procédé de fabrication d'une cellule solaire selon la revendication 10, dans lequel la seconde étape comprend des étapes qui consistent à produire une couche de blocage (201, 202), formée par croissance épitaxiale, dans une position prédéterminée comprenant une partie située au-dessus de la région de semiconducteur (102) de la surface du substrat semiconducteur, et à produire ensuite successivement une première couche de semiconducteur (203) du second type de conductivité et une seconde couche de semiconducteur (204) du premier type de conductivité.

14. Un procédé de fabrication d'une cellule solaire selon la revendication 10, dans lequel la seconde étape comprend des étapes qui consistent à produire une couche de fenêtre (205) sur la seconde couche de semiconducteur (204).

15. Un procédé de fabrication d'une cellule solaire selon la revendication 10, dans lequel le substrat semiconducteur (100) consiste en Ge et les première et seconde couches de semiconducteur consistent en GaAs.

16. Un procédé de fabrication d'une cellule solaire selon la revendication 15, dans lequel le substrat semiconducteur (100) consiste en une couche de Ge de type p, la région de semiconducteur (102) consiste en une couche de Ge de type n, la première couche de semiconducteur (203) consiste en une couche de GaAs de type n et la seconde couche de semiconducteur (204) consiste en une couche de GaAs de type p.

17. Un procédé de fabrication d'une cellule solaire selon la revendication 10, dans lequel le substrat semiconducteur consiste en Si et les seconde et troisième couches de semiconducteur consistent en GaAs.

18. Un procédé de fabrication d'une cellule solaire selon la revendication 10, dans lequel une zone (402) située au-dessus de la région de semiconducteur (102), parmi des zones de la première électrode (401, 402) qui est produite sur la première surface principale du substrat semiconducteur (100), constitue une partie de connexion pour un connecteur externe.
